# EUROPÄISCHE PATENTANMELDUNG

(11) **EP 0 828 280 A2**
(43) Veröffentlichungstag der Anmeldung: **11.03.1998**
(21) Anmeldenummer: 97112907.7
(22) Anmeldetag: 26.07.1997
(51) Int. Cl.: H01J 3/40, H01J 3/02

(54) **Verfahren und Vorrichtung zur Erzeugung von Elektronenstrahlen**

(30) Priorität: 24.08.1996 DE 19634304
(71) Anmelder: MaK System Gesellschaft mbH, D-24159 Kiel (DE)
(72) Erfinder: Sermund, Gerald, Dr., 24118 Kiel (DE)
(74) Vertreter: Hansmann, Dierk, Dipl.-Ing.

(57) **Zusammenfassung**

Das Verfahren dient zur Erzeugung eines Elektronenstrahles. Es werden von einer Kathode (1) Elektronen emittiert und von einem elektrischen Feld in Richtung auf eine Anode (3) transportiert. Die Anode umschließt den Elektronenstrahl bereichsweise hohlzylinderartig. Der Elektronenstrahl wird im Bereich der Anode von einem Strahlzentrierer mit Zentrierspule (9) zentriert. In einer Umgebung der Kathode ist eine Wehneltelektrode (2) angeordnet, die den Elektronenstrahl hohlzylindrisch umgibt. Die Wehneltelektrode ist mit einer Wehneltspannung beaufschlagt. Ein von der Anode abfließender Anodenstrom wird bei abgeschalteter Wehneltregelung meßtechnisch erfaßt. Der Anodenstrom wird von einer Zentriersteuerung durch Veränderung eines Zentrierspulenstromes minimiert. Anschließend wird die Wehneltspannung in Abhängigkeit vom Anodenstrom zur Annäherung an einen Anodenstromsollwert verändert.

## Beschreibung

Die Erfindung betrifft ein Verfahren zur Erzeugung eines Elektronenstrahles, bei dem die von einer Kathode emittierten Elektronen von einem elektrischen Feld in Richtung auf eine den Elektronenstrahl bereichsweise hohlzylinderartig umschließende Anode beschleunigt werden, bei dem der Elektronenstrahl im Bereich der Anode von einem Strahlzentrierer mit Zentrierspule zentriert wird und bei dem eine den Elektronenstrahl hohlzylindrisch umgebende spannurigsbeaufschlagte Wehneltelektrode vorgesehen ist.

Die Erfindung betrifft darüber hinaus eine Vorrichtung zur Erzeugung eines Elektronenstrahles, die eine Elektronen emittierende Kathode und eine die Elektronen entlang eines elektrischen Feldes leitende Anode aufweist, die den Elektronenstrahl bereichsweise hohlzylinderartig umschließt und die einen Strahlzentrierer mit Zentrierspule aufweist, die den Elektronenstrahl im Bereich der Anode zentriert und bei der in einer Umgebung der Kathode eine Wehnelelektrode angeordnet ist, die den Elektronenstrahl hohlzylindrisch umgibt sowie an eine Wehneltspannungsversorgung angeschlossen ist.

Bekannte Einrichtungen nach dem Stand der Technik, wie zum Beispiel gemäß DE-A-40 32 918 oder DE-A-44 30 534.6, betreffen Elektronenstrahl-Erzeuger, die aus einer Elektronen emittierenden Kathode und einer Anode mit einer Anodenbohrung zum Durchtritt des Elektronenstrahls entlang einer elektronenoptischen Strahlachse bestehen, wobei Kathode, Anode und eine Wehneltelektrode in einer Vakuumkammer angeordnet sind.

Ein derartiger Elektronenstrahl-Erzeuger kann in Elektronenstrahl-Geräten für die Materialbearbeitung Anwendung finden, beispielsweise in Elektronenstrahl-Graviereinrichtungen für die Gravur von Oberflächenstrukturen auf Texturwalzen, mit denen in Walzwerken Feinbleche zur Qualitätsverbesserung bearbeitet werden.

Eine derartige Elektronenstrahl-Graviereinrichtung besteht im wesentlichen aus einer ersten Vakuumkammer, in der ein Elektronenstrahl-Erzeuger und ein elektronenoptisches Steuerungssystem für den Elektronenstrahl untergebracht sind, und aus einer zweiten Vakuumkammer, in der sich die Texturwalze zur Gravur mit dem Elektronenstrahl befindet. Der Elektronenstrahl-Erzeuger besteht im wesentlichen aus einer Kathode, eine Anode mit einer Anodenbohrung und aus einer Wehneltelektrode. Die den Elektronenstrahl erzeugenden Elektronen werden von der beheizten Kathode, die auf Hochspannungspotential liegt, emittiert und in Richtung auf die Anode, die beispielweise Nullpotential hat, beschleunigt. Der Elektronenstrahl wird durch die Anodenbohrung dem elektronenoptischen Steuerungssystem zugeführt und tritt dann durch eine Öffnung in der ersten Vakuumkammer in die zweite Vakuumkammer als Arbeitskammer ein, um die Texturwalze zu bearbeiten.

Bei Elektronenstrahl-Geräten, wie beispielsweise den Elektronenstrahl-Graviereinrichtungen, die mit Hochspannung im kV-Bereich und im Hochvakuum betrieben werden, treten im Elektronenstrahl-Erzeuger Ionen auf, die durch Ionisation von Restgasmolekülen entstehen. Diese Ionen werden auf die Kathode beschleunigt und zerstören durch Materialabtrag die Kathode, wobei insbesondere aus dem Beschleunigungsraum stammende, dicht vor der Kathode gebildete Ionen an der Zerstörung der Kathode beteiligt sind.

Die Zerstörung der Kathode durch den Ionenbeschuß macht häufige Wartungsarbeiten an dem Elektronenstrahl-Erzeuger erforderlich, bei denen die zerstörte Kathode gegen eine neue Kathode ausgetauscht werden muß. Die Wartungsarbeiten führen in nachteiliger Weise zu Stillstandszeiten der Elektronenstrahl-Geräte. Darüber hinaus wird durch den vom Ionenbeschuß verursachten Materialabtrag von der Kathode die aktive Emissionsfläche verkleinert und das Stromdichteprofil des Elektronenstrahls in nachteiliger Weise verändert.

In den bekannt gewordenen Systemen führen zwei Effekte zur Einschränkung der Standzeit:
a) Durch die hohe Temperatur der Kathode kommt es im Hochvakuum zu einer Abdampfung des Kathodenmaterials. Dadurch wird die Kathode im Laufe der Einsatzzeit immer dünner. Typische Standzeiteinschränkungen durch diesen Effekt sind ca. 25 Stunden.
b) Die im Strahlerzeuger gebildete Ionen werden durch das elektrische Feld zwischen Kathode und Anode beschleunigt und hauptsächlich auf die Emissionsfläche der Kathode gelenkt. Dort schlagen sie aus dem Kathodenmaterial Atome heraus. Auf diese Weise wird die Emissionsfläche uneben und der Elektronenstrahl verliert seine gewünschte gleichförmige Stromdichteverteilung. Die typische Standzeiteinschränkung durch diesen Effekt beträgt ca. zwei Stunden.

Aufgabe der vorgeschlagenen Erfindung ist es, durch den Einsatz eines modifizierten Strahlenerzeugersystems die Standzeit der Kathoden, das heißt die Zeitspanne, während der diese in der Lage sind, einen homogenen Elektronenstrahl mit gleichförmiger Stromdichteverteilung zu erzeugen, erheblich zu verlängern.

Diese Aufgabe wird erfindungsgemäß dadurch gelöst, daß der von der Anode abfließende Anodenstrom bei abgeschalteter Wehneltregelung meßtechnisch erfaßt wird, daß der Anodenstrom von einer Zentriersteuerung durch Veränderung eines Zentrierspulenstromes minimiert wird, daß der Zentrierstrom durch Veränderung des Stromes durch eine im Bereich der Kathode angeordnete Kathoden-Magnetspule minimiert wird, und daß anschließend die Wehneltspannung in Abhängigkeit vom Anodenstrom zur Annäherung an einen Anodenstromsollwert verändert wird.

Weitere Aufgabe der vorliegenden Erfindung ist es, eine Vorrichtung der einleitend genannten Art zur Verbesserung der Standzeit zu modifizieren.

Diese Aufgabe wird erfindungsgemäß dadurch gelöst, daß zur meßtechnischen Erfassung eines von der Anode abfließenden Anodenstromes eine Meßeinrichtung mit der Anode verbunden ist, daß zur Versorgung der Zentrierspule und zur Minimierung des Zentrierspulenstromes eine Zentriersteuerung an die Zentrierspule angeschlossen ist und daß zur Veränderung der Wehnelt-Spannung in Abhängigkeit vom Anodenstrom eine Wehnelt-Steuerung an die Wehneltelektrode angeschlossen ist.

Durch die Abstimmung der Wehneltspannung sowie der Strahlzentrierung wird die Anzahl der sich bildenden Ionen deutlich vermindert und gegebenenfalls vorhandene Ionen können abgeleitet werden oder treffen mit verminderter Geschwindigkeit auf der Kathode auf. Ein Materialabtrag aus dem Bereich der Kathode kann hierdurch erheblich reduziert werden. Ebenfalls treffen gegebenenfalls verbleibende Ionen nicht in einem Zentralbereich, sondern nur in Randbereichen der Kathode auf.

Eine weitere Verbesserung der Strahlgeometrie kann dadurch erfolgen, daß nach Annäherung des Anodenstromes an den Anodenstromsollwert eine erneute Zentrierung des Elektronenstrahles sowie eine anschließende Anpassung der Wehneltspannung durchgeführt wird.

Zur Optimierung der Elektrodenemission wird vorgeschlagen, daß von einer Heizstromregelung ein Emissionsstrom durch die Kathode hindurch erfaßt und mit einem Sollwert verglichen wird und daß in Abhängigkeit vom Vergleichsergebnis eine Vorgabe des Heizstromes durchgeführt wird.

Zur Verhinderung eines Auftreffens des Elektrodenstrahles auf die Anode beim Ausfall des Spulensystems wird vorgeschlagen, daß die Kathode relativ zur Anode positionierbar ist und daß eine Verschiebung der Kathode gemeinsam mit einem Strahlkopf durchgeführt wird.

Eine einfache meßtechnische Erfassung wird dadurch unterstützt, daß die Erfassung des Anodenstromes über einen Meßwiderstand durchgeführt wird.

Zur Bereitstellung eines Istwertes für die Wehneltregelung wird vorgeschlagen, daß der Eingangswert für die Durchführung der Wehneltregelung über den gleichen Meßwiderstand wie zur Ansteuerung der Strahlzentrierung erfaßt wird.

Die spezielle Anordnung der festen Verschiebung des Strahlkopfes mit der Kathode zur Lage der Anode verhindert zusätzlich, daß bei einem Ausfall des Spulensystems der Elektronenstrahl auf die Anode treffen und sie zerstören kann. Die Auslegung der Regelung als vollautomatisches System ermöglicht es zudem, Langzeiteffekte wie thermische oder magnetische Drift stets wieder ausgleichen zu können.

Bei der vorgeschlagenen Anordnung versorgt ein Hochspannungsgenerator (HG) den Strahlerzeuger mit der benötigten Hochspannung von vorzugsweise 25 bis 50 kV. Die Heizstromregelung (HR) mißt die Spannung Ue über einen Meßwiderstand Re für den Emissionsstrom Ie, vergleicht sie mit der Sollwertspannung` UeS des Heizstrom-Sollwertgebers (HSG) und regelt bei Bedarf den Heizstrom Ih über die Heizstrom-Stromquelle (HSQ) nach, bis der Emissionsstrom Ie den optimalen Wert hat. Der Zentrierstrom-Regler und -Minimierer (ZSR) mißt die Spannung Ua über einen Meßwiderstand Ra für den AnodenStrom Ia und minimiert den im Anodenstromsensor der Anode ausgeblendeten Anteil des Emissionsstroms (e-Beam), daß heißt den Anodenstrom Ia, der nicht als wirksamer Elektronenstrahl die Anode über die Anodensensorbohrung durchtritt. Dies erfolgt über die Regelung der Zentrierstromquelle (ZSQ), die den magnetischen Anodenzentrierer Zo mit dem Zentrierstrom Iz versorgt. Während des Minimier- und Zentriervorganges ist die Wehneltregelung (WR) nicht aktiv.

Die Wehneltregelung (WR) mißt ebenfalls die Spannung Ua über den Meßwiderstand Ra für den im Anodenstromsensor ausgeblendeten, zentrierten Emissionsstrom Ia, vergleicht sie mit der Sollwertspannung UaS des Wehneltspanungs-Sollwertgebers (WSG) und regelt bei Bedarf die Wehneltspannung Uw über die Wehneltspannungsquelle (WSQ) nach, bis der ausgeblendete Emissionsstrom, daß heißt der Anodenstrom Ia, den optimalen Wert hat.

Ein Kathoden-Spulenstrom-Sollwertgeber (SSG) gibt einer Kathoden-Spulenstromquelle einen Wert für den Kathoden-Spulenstrom Is vor und veranlaßt den Zentrierstrom-Regler und -Minimierer (ZSR) zur Zentrierung des Elektronenstrahls (e-Beam) wie oben beschrieben. Durch mehrfache Wiederholung dieses Vorgangs bei verschiedenen Kathoden-Spulenstromwerten Is wird derjenige Kathoden-Spulenstromwert ermittelt, der den geringsten Strom Iz durch die Zentrierspulen ZO zur Folge hat. Während der Variation des Kathoden-Spulenstroms Is und des Minimier- und Zentriervorgangs durch die Variation des Zentrierstroms Iz ist die Wehneltregelung (WR) nicht aktiv.

In der Zeichnung sind Ausführungsbeispiele der Erfindung schematisch dargestellt. Es zeigen:
- Fig. 1: ein Prinzipbild der Gesamtanordnung,
- Fig. 2: eine Ansicht des Strahlerzeugersystems von oben,
- Fig. 3: eine Ansicht des Strahlerzeugersystems von der Seite
**und**
- Fig. 4: eine Ansicht eines grundsätzlichen Aufbaus des Strahlerzeugersystems.

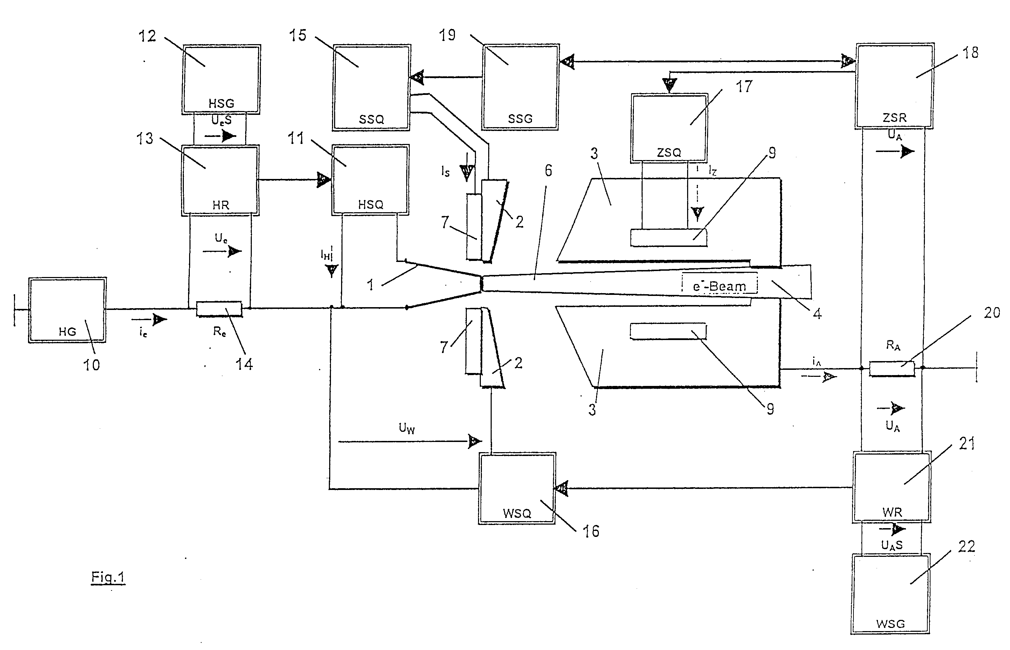

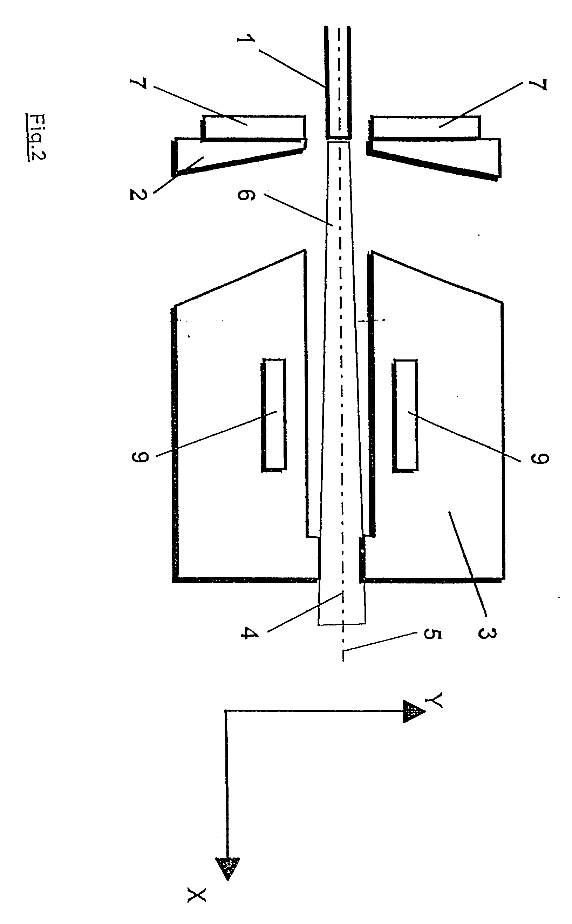

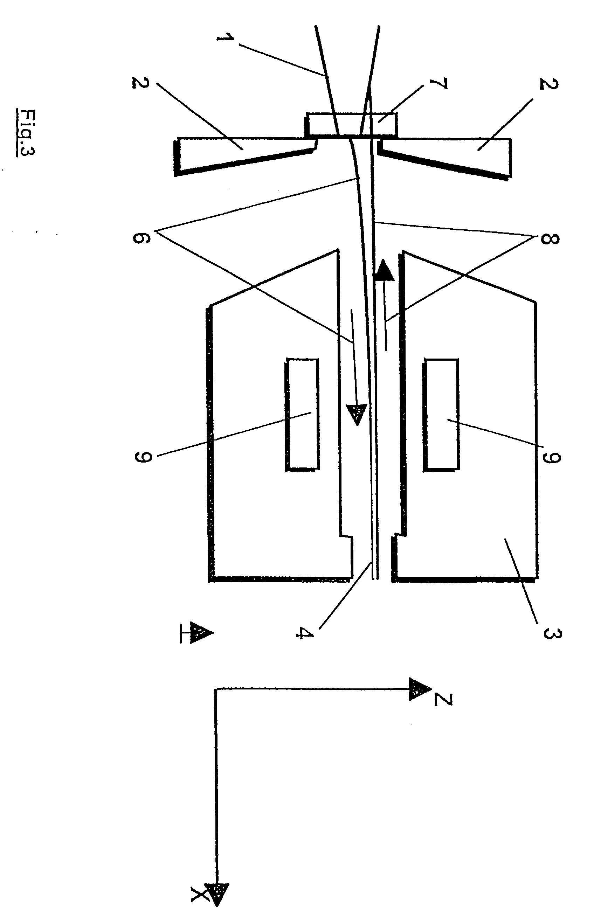

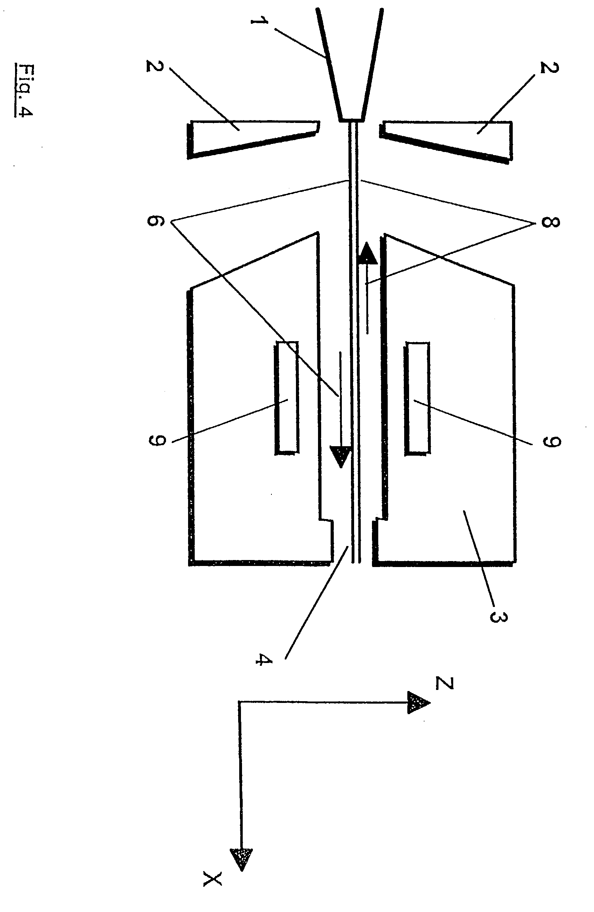

In Fig. 1 wird der Aufbau der vorgeschlagenen Gesamtanlage dargestellt. Eine Kathode (1), die an einen Hochspannungsgenerator (10) HG angeschlossen ist, bildet mit einer ringförmigen Anode (3) (aufgeschnitten), die mit einer Anodensensorbohrung (4) versehen ist, einen zentralen Elektronenbeschleuniger für einen Elektronenstrahl (6) (e-Beam). An die Kathode (1) ist ebenfalls eine Heizstromquelle (11) HSQ angeschlossen, die mittels eines Heizstroms Ih eine Kathodenheizung versorgt, welche die zu beschleunigenden freien Elektronen an der Kathode (1) erzeugt. Ein Heizstromsollwertgeber (12) HSG gibt die Heizstromsollwertspannung UeS an eine Heizstromregelung (13) vor, welche den Emissionsstrom Ie über den Meßwiderstand (14) Re für den Emissionsstrom mißt und die Heizstromquelle (13) entsprechend dem gewünschten Emissionsstrom ansteuert.

An der Kathode (1) ist vorn links und rechts eine Kathoden-Magnetspule (7) angeordnet und im Anschluß daran wird die Kathode (1) von einer ringförmigen, hier aufgeschnittenen, Wehneltelektrode (2) umgeben. Die Kathodenmagnetspule (7) ist an eine Spulenstromquelle (15) SSQ angeschlossen. Die Wehneltelektrode (2) ist sowohl an die Spulenstromquelle SSQ als auch an eine Wehneltspannungsquelle (16) WSQ angeschlossen.

In der ringförmigen Anode (3) sind Zentrierspulen (9) untergebracht, die von einer Zentrierstromquelle (17) mit einem Strom Iz versorgt werden. Die Zentrierstromquelle (17) ZSQ erhält ihre Stromvorgabe von einem Zentrierstromregler- und minimierer (18) ZSR. Der Zentrierstromregler und -minimierer (18) ZSR steuert auch einen Spulensollwertgeber (19) SSG, der den Sollwert an die Spulenstromquelle (15) SSQ vorgibt, und mißt gleichzeitig die Regelgröße Spannung Ua über einen Meßwiderstand (20) Ra des Anodensensorstroms Ia. Die Meßspannung Ua wird ebenfalls von einer Wehneltregelung (21) WR benutzt, die eine Sollwertspannung UaS von einem Wehneltsollwertgeber (22) WSG erhält und die Wehneltspannungsquelle (16) ansteuert.

In Fig. 2 ist die vorgeschlagene Anordnung in der Draufsicht und in Fig. 3 in der Seitenansicht dargestellt. Die Anordnung ist rotationssymmetrisch um eine Strahlachse (5) aufgebaut, die durch die Kathode (1) und den als keulenartige Ausformung dargestellten Elektronenstrahl (6) verläuft. Die Darstellung erfolgt in einer Ansicht von oben, Bildebene X-Y.

Die aufgeschnittene Anode (3) enthält die Zentrierspulen (9) und die Anodensensorbohrung (4) mit dem Durchtritt des Elektronenstrahls (6). An der Kathode sind links und rechts die Kathoden-Magnetspule (7) angeordnet und daneben rechts ist die konzentrische aufgeschnittene Wehneltelektrode (2) dargestellt.

In der Seitenansicht der Fig. 3 ist eine Verschiebung der Anodenachse gegenüber der Kathodenachse in der Zeichenebene X-Z dargestellt. Ebenfalls ist die mittlere Bahn des Elektronenstrahls (6) und die Bahn der Ionenbewegung (8) abgebildet. Die Elektronen (6) fliegen entsprechend ihrer elektrischen Ladung von der Kathode (1) zur Anode (3). Die Ionen bewegen sich entlang der Ionenbahn (8) entsprechend ihrer entgegengesetzten elektrischen Ladung von der Anode (3) zur Kathode (1). Da Kathode (1) und Anode (3) in der Bildebene X-Z achsenversetzt sind, treffen die Ionen nicht auf dem zentralen Teil der Kathode (1) sondern oberhalb seitlich an der Kathode (1) auf. In der vorgeschlagenen Anordnung werden alle Betriebsparameter so eingestellt und geregelt, daß möglichst viele beziehungsweise alle Ionen nicht auf den zentralen Teil der Kathode (1) sondern seitlich auf die Kathode (1) auftreffen.

In Fig. 4 ist zum Unterschied und zum besseren Verständnis eine Anordnung dargestellt, bei der nach einer Deaktivierung der Bauelemente zur Stahlausbildung keine Strahlbeeinflussung durch die Magnetspule (7) und keine Regelung der Parameter vorgenommen wird und alle Ionen entlang des Ionenweges (8) in schädlicher Weise auf den zentralen Teil der Kathode (1) auftreffen.

## Patentansprüche

1. Verfahren zur Erzeugung eines Elektronenstrahles, bei dem die von einer Kathode emittierten Elektronen von einem elektrischen Feld in Richtung auf eine den Elektronenstrahl bereichsweise hohlzylinderartig umschließende Anode beschleunigt werden, bei dem der Elektronenstrahl im Bereich der Anode von einem Strahlzentrierer mit Zentrierspule zentriert wird und bei dem eine den Elektronenstrahl hohlzylindrisch umgebende spannungsbeaufschlagte Wehneltelektrode vorgesehen ist, dadurch gekennzeichnet, daß der von der Anode (3) abfließende Anodenstrom bei abgeschalteter Wehneltregelung (21) meßtechnisch erfaßt wird, daß der Anodenstrom von einer Zentriersteuerung durch Veränderung eines Zentrierspulenstromes minimiert wird, daß der Zentrierstrom durch Veränderung des Stromes durch eine im Bereich der Kathode angeordnete Kathoden-Magnetspule (7) minimiert wird, und daß anschließend die Wehneltspannung in Abhängigkeit vom Anodenstrom zur Annäherung an einen Anodenstromsollwert verändert wird.

2. Verfahren nach Anspruch 1, dadurch gekennzeichnet, daß nach Annäherung des Anodenstromes an den Anodenstromsollwert eine erneute Zentrierung des Elektronenstrahles sowie eine anschließende Anpassung der Wehneltspannung durchgeführt wird.

3. Verfahren nach einem der Ansprüche 1 oder 2, dadurch gekennzeichnet, daß von einer Heizstromregelung ein Emissionsstrom durch die Kathode (1) erfaßt und mit einem Sollwert verglichen wird und daß in Abhängigkeit vom Vergleichsergebnis eine Vorgabe des Heizstromes durchgeführt wird.

4. Verfahren nach einem der Ansprüche 1 bis 3, dadurch gekennzeichnet, daß die Kathode relativ zur Anode positionierbar ist und daß eine Verschiebung der Kathode gemeinsam mit einem Strahlkopf durchgeführt wird.

5. Verfahren nach einem der Ansprüche 1 bis 4, dadurch gekennzeichnet, daß die Erfassung des Anodenstromes über einen Meßwiderstand durchgeführt wird.

6. Verfahren nach einem der Ansprüche 1 bis 5, dadurch gekennzeichnet, daß der Eingangswert für die Durchführung der Wehneltregelung über den gleichen Meßwiderstand wie zur Ansteuerung der Strahlzentrierung erfaßt wird.

7. Vorrichtung zur Erzeugung eines Elektronenstrahles, die eine Elektronen emittierende Kathode und eine die Elektronen entlang eines elektrischen Feldes leitende Anode aufweist, die den Elektronenstrahl bereichsweise hohlzylinderartig umschließt und die einen Strahlzentrierer mit Zentrierspule aufweist, die den Elektronenstrahl im Bereich der Anode zentriert und bei der im Bereich der Kathode eine Wehneltelektrode angeordnet ist, die den Elektronenstrahl hohlzylindrisch umgibt sowie an eine Wehneltspannungsversorgung angeschlossen ist, dadurch gekennzeichnet, daß zur meßtechnischen Erfassung eines von der Anode (3) abfließenden Anodenstromes eine Meßeinrichtung mit der Anode verbunden ist, daß zur Versorgung der Zentrierspule (9) und zur Minimierung des Zentrierspulenstromes eine Zentriersteuerung an die Zentrierspule (9) angeschlossen ist und daß zur Veränderung der Wehneltspannung in Abhängigkeit vom Anodenstrom eine Wehneltsteuerung an die Wehneltelektrode (2) angeschlossen ist.
